(19) Europäisches Patentamt
European Patent Office
Office européen des brevets

(11) **EP 4 355 062 B1**

(12) **FASCICULE DE BREVET EUROPEEN**

(45) Date de publication et mention
de la délivrance du brevet:
**26.02.2025 Bulletin 2025/09**

(21) Numéro de dépôt: **23203608.7**

(22) Date de dépôt: **13.10.2023**

(51) Classification Internationale des Brevets (IPC):
*H10N 10/01* (2023.01)   *H10N 10/851* (2023.01)
*B22F 10/28* (2021.01)   *B33Y 80/00* (2015.01)
*B22F 7/04* (2006.01)   *B33Y 10/00* (2015.01)

(52) Classification Coopérative des Brevets (CPC):
**H10N 10/01; B22F 7/04; B22F 10/28; B33Y 10/00;
B33Y 80/00; H10N 10/8556;** B22F 2007/042;
H10N 10/817

(54) **PROCEDE DE FABRICATION D'UNE STRUCTURE THERMOELECTRIQUE**

VERFAHREN ZUR HERSTELLUNG EINER THERMOELEKTRISCHEN STRUKTUR

METHOD FOR MANUFACTURING A THERMOELECTRIC STRUCTURE

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **14.10.2022 FR 2210613**

(43) Date de publication de la demande:
**17.04.2024 Bulletin 2024/16**

(73) Titulaire: **Commissariat à l'Energie Atomique et
aux Energies
Alternatives
75015 Paris (FR)**

(72) Inventeurs:
• **SAVELLI, Guillaume
38054 GRENOBLE CEDEX 09 (FR)**
• **BAUDRY, Maxime
38054 GRENOBLE CEDEX 09 (FR)**
• **ROUX, Guilhem
38054 GRENOBLE CEDEX 09 (FR)**

(74) Mandataire: **Brevalex
Tour Trinity
1 B Place de la Défense
92400 Courbevoie (FR)**

(56) Documents cités:
**EP-A1- 3 985 745     WO-A1-2020/066948
CN-A- 112 158 811     CN-B- 106 384 779
US-A1- 2017 069 817**

• **EL-DESOUKY AHMED ET AL: "Rapid processing
and assembly of semiconductor thermoelectric
materials for energy conversion devices",
MATERIALS LETTERS, vol. 185, 1 August 2016
(2016-08-01), pages 598 - 602, XP029810531,
ISSN: 0167-577X, DOI: 10.1016/
J.MATLET.2016.07.152**

## Description

### DOMAINE TECHNIQUE

La présente invention se rapporte au domaine général des modules thermoélectriques. L'invention concerne un procédé de fabrication de structures thermoélectriques. L'invention concerne également une structure thermoélectrique obtenue par un tel procédé.

L'invention concerne également des dispositifs thermoélectriques comprenant deux structures thermoélectriques ainsi obtenues, l'une étant d'un premier type de conductivité et l'autre étant d'un deuxième type de conductivité.

L'invention trouve des applications dans de nombreux domaines industriels, et notamment pour les applications ayant besoin de générateurs thermoélectriques, où un gradient thermique est disponible (exemple transports, industries, etc.), les applications de générateur thermoélectrique à radioisotope, les applications Peltier ou encore les applications de capteurs thermiques.

L'invention est particulièrement intéressante puisqu'elle permet de former des structures/dispositifs thermoélectriques présentant de faibles résistivités.

### ÉTAT DE LA TECHNIQUE ANTÉRIEURE

Généralement, les modules thermoélectriques (TE) comprennent un ensemble de premiers plots en un matériau thermoélectrique d'un premier type de conductivité et un ensemble de deuxièmes plots en un matériau thermoélectrique d'un deuxième type de conductivité. Par exemple, le premier matériau est un matériau de type N (i.e. à conductivité de type N) et le deuxième matériau est un matériau de type P (i.e. à conductivité de type P).

Les plots sont connectés électriquement en série et thermiquement en parallèle. Les plots sont reliés entre eux par des éléments métalliques. Les jonctions thermoélectriques sont aussi appelées jonctions NP. Les plots sont maintenus par des substrats en céramique disposés de part et d'autre des ensembles de plots.

Les performances électriques d'un dispositif TE en mode générateur sont données par :

- une résistance électrique interne $R_{int}$ définie selon (1) :

$$R_{int} = N \times \rho_{np} \times L / A + R_c + R_{met} \; (1)$$

avec N le nombre de jonctions NP, $\rho_{np}$ la résistivité électrique des matériaux NP, L la longueur d'une ligne ou épaisseur d'un plot, A la section d'une ligne ou d'un plot, $R_c$ la résistance totale des contacts et $R_{met}$ la résistance totale des jonctions métalliques

- une puissance électrique utile Pu définie selon (2) :

$$Pu = V_{oc}^2 / 4R_{int}$$

avec $V_{oc}$ la tension générée par le module TE

Ainsi, pour disposer d'une puissance élevée, il faut avoir une résistance électrique interne faible, et donc diminuer la contribution de la résistance totale des contacts $R_c$ et de la résistance totale des jonctions métalliques $R_{met}$.

Classiquement, la fabrication des modules TE est généralement réalisée à partir des étapes suivantes : fabrication des matériaux TE (frittage), mise en forme des plots, métallisation des plots, assemblage avec les substrats.

Les connections métalliques sont réalisées directement sur les substrats, par exemple par la technique dite du cuivre direct (ou DBC pour 'Direct Bonding Copper'), puis brasage et pressage avec les plots.

Cependant, ce procédé de fabrication est relativement complexe et limite beaucoup la géométrie et la modularité du dispositif thermoélectrique fabriqué.

Il existe également des modules TE sans substrat, aussi appelés "modules squelettes". Ces modules n'ont donc pas de perte thermique due aux substrats. Cependant, ils ne peuvent être en contact avec des surfaces conductrices électriquement.

Il est également possible d'utiliser des plots TE réalisés à partir de plusieurs matériaux TE. Ces plots dits segmentés permettent de s'accommoder d'une plus grande différence de température aux extrémités du module car les matériaux utilisés sont généralement optimisés pour des gammes de température différentes. WO 2020/066948 A1 (AISIN TAKAOKA LTD [JP]) 2 avril 2020 (2020-04-02) divulgue un procédé de fabrication d'une structure thermoélectrique comprenant fournir un substrat en un premier matériau et déposer un élément thermoélectrique en un deuxième matériau sur le substrat, par fabrication additive.

### EXPOSÉ DE L'INVENTION

Un but de la présente invention est de proposer un procédé de fabrication de structures thermoélectriques, simple à mettre œuvre, et permettant de fabriquer des structures thermoélectriques ayant de bonnes propriétés électriques (notamment, une faible résistance de contact) et/ou de bonnes propriétés thermiques.

Pour cela, la présente invention propose un procédé de fabrication d'une structure thermoélectrique comprenant les étapes suivantes :

    a) fournir un substrat en un premier matériau,
    b) déposer un élément thermoélectrique en un deuxième matériau sur le substrat, par fabrication additive,
    c) amincir et découper le substrat, jusqu'à obtenir un film en premier matériau, moyennant quoi on obtient une structure thermoélectrique comprenant un film en premier matériau et l'élément thermoélectrique.

L'invention se distingue fondamentalement de l'art antérieur par la mise en œuvre d'une étape au cours de laquelle la fonctionnalisation (métallisation) de l'élément thermoélectrique (par exemple un plot thermoélectrique) est réalisée lors du procédé de fabrication additive.

Ceci conduit non seulement à une diminution conséquente du nombre d'étapes et donc à une simplification du procédé par rapport aux procédés de l'art antérieur, mais aussi à un gain de temps considérable et à une diminution des coûts.

La métallisation obtenue présente une bonne tenue mécanique et de bonnes propriétés de conduction électrique et/ou thermique.

De préférence, la technique de fabrication additive est une technique de fusion laser sur lit de poudre (FLLP ou PBF pour "Powder Bed Fusion" en terminologie anglo-saxonne) ou une technique de frittage sélectif par laser (FLS ou SLS pour "Selective Laser Sintering"). Avantageusement, le substrat est recouvert, complètement ou localement, par une couche d'accroche métallique en un troisième matériau et l'élément thermoélectrique est formé sur la couche d'accroche métallique, moyennant quoi on obtient une structure thermoélectrique comprenant un film, une couche d'accroche et un élément thermoélectrique, le troisième matériau étant de préférence choisi parmi Al, Ti, Cu, Au et Ni.

Selon un mode de réalisation avantageux, l'élément thermoélectrique est une pièce ayant la forme d'un peigne délimitant une base et une pluralité de branches, sensiblement parallèles entre elles, s'étendant sensiblement orthogonalement à partir de la base, la pluralité de branches ayant une première extrémité et une deuxième extrémité, la première extrémité étant reliée à la base, et la deuxième extrémité étant en contact avec le film ou le cas échéant en contact avec la couche d'accroche métallique.

Selon un autre mode de réalisation avantageux, l'élément thermoélectrique est un plot, ayant une base et une hauteur.

Selon cet autre mode de réalisation avantageux, le substrat peut être découpé de manière à avoir un film ayant une même surface que la surface de la base du plot. Alternativement, le substrat peut être découpé de manière à avoir un film ayant une surface supérieure à la surface de la base du plot.

Avantageusement, lors de l'étape b), plusieurs plots sont déposés et le substrat est découpé de manière à avoir une structure comprenant un film sur lequel sont disposés plusieurs plots.

Avantageusement, entre l'étape b) et l'étape c), le procédé comprend une étape additionnelle au cours de laquelle on dépose, sur l'élément thermoélectrique, une couche de métallisation intermédiaire puis un élément thermoélectrique additionnel en un quatrième matériau ayant un type de conductivité opposé au type de conductivité du deuxième matériau. Par exemple, le deuxième matériau est de type N et le quatrième matériau est de type P (ou inversement).

Avantageusement, le deuxième matériau est Si, SiGe, $Bi_2Te_3$, Half-Heusler ou Skutterudites.

Le quatrième matériau peut également être choisi parmi Si, SiGe, $Bi_2Te_3$, Half-Heusler et Skutterudites. Par exemple, le deuxième matériau est en SiGe dopé N et le quatrième matériau est en SiGe dopé P.

Avantageusement, le premier matériau est de l'acier 316L, de l'aluminium, du titane, un alliage CuZr, une céramique ou du graphite.

Le procédé présente de nombreux avantages :

- il présente un faible nombre d'étapes,
- il est simple et économique,
- il autorise une grande modularité de conception du dispositif thermoélectrique fabriqué, par exemple,
- les éléments thermoélectriques peuvent avoir des formes simples (un plot par exemple) ou des formes complexes (un peigne par exemple).

L'invention concerne également une structure thermoélectrique obtenue par un tel procédé.

La structure thermoélectrique comprend un film, par exemple en acier 316L, aluminium, titane, alliage CuZr, céramique ou graphite, sur lequel est disposé un ou plusieurs éléments thermoélectriques.

Avantageusement, une couche d'accroche métallique, par exemple en Al, Ti, Cu, Au ou Ni, est disposée entre le film et le ou les éléments thermoélectriques.

La fabrication additive permet de réaliser des formes complexes, ce qui n'est pas possible avec les techniques actuelles de fabrication de matériaux TE. Les formes complexes sont, par exemple, des formes circulaires. Il est également possible de réaliser des éléments thermoélectriques présentant des cavités ou encore des éléments thermoélectriques en forme de nid d'abeille ou de spirale. Des formes carrées, plus simples à mettre en œuvre, sont également réalisables.

L'invention concerne également un dispositif thermoélectrique comprenant deux structures thermoélectriques obtenues par un procédé tel que décrit précédemment, chaque structure thermoélectrique comprenant un film, par exemple en acier 316L, aluminium, titane, alliage CuZr, céramique ou graphite, et un ou plusieurs éléments thermoélectriques, une couche d'accroche métallique, par exemple en Al, Ti, Cu, Au ou Ni, pouvant être disposée entre le film et le ou les éléments thermoélectriques des deux structures thermoélectriques, le ou les éléments thermoélectriques d'une des structures thermoélectrique étant d'un premier type de conductivité et le ou les éléments thermoélectriques de l'autre structure thermoélectrique étant d'un deuxième type de conductivité opposé au premier type de conductivité.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

Les Fig. 1A, Fig. 1B et Fig. 1C représentent, de manière schématique et en coupe, les différentes étapes d'un procédé de fabrication d'une structure thermoélectrique selon un premier mode de réalisation de l'invention.

Les Fig. 2A, Fig. 2B, Fig. 2C et Fig. 2D représentent, de manière schématique et en coupe, les différentes étapes d'un procédé de fabrication d'une structure thermoélectrique selon un deuxième mode de réalisation de l'invention.

Les Fig. 3A, Fig. 3B, Fig. 3C, Fig. 3D et Fig. 3E représentent, de manière schématique et en coupe, les différentes étapes d'un procédé de fabrication d'un dispositif thermoélectrique selon un troisième mode de réalisation de l'invention.

Les Fig. 4A, Fig. 4B, Fig. 4C, Fig. 4D, Fig. 4E et Fig. 4F représentent, de manière schématique et en coupe, les différentes étapes d'un procédé de fabrication d'un dispositif thermoélectrique selon un quatrième mode de réalisation de l'invention.

Les Fig. 5A, Fig. 5B et Fig. 5C représentent, de manière schématique et en coupe, les différentes étapes d'un procédé de fabrication d'une structure thermoélectrique selon un cinquième mode de réalisation de l'invention.

Les Fig. 6A, Fig. 6B, Fig. 6C et Fig. 6D représentent, de manière schématique et en coupe, les différentes étapes d'un procédé de fabrication d'une structure thermoélectrique selon un sixième mode de réalisation de l'invention.

La Fig. 7 est un cliché photographique de plots thermoélectriques déposés sur un substrat selon un mode de réalisation particulier de l'invention.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation, tels que "dessus", "dessous", etc. d'une structure s'appliquent en considérant que la structure est orientée de la façon illustrée sur les figures.

## EXPOSÉ DÉTAILLÉ DE MODES DE RÉALISATION PARTICULIERS

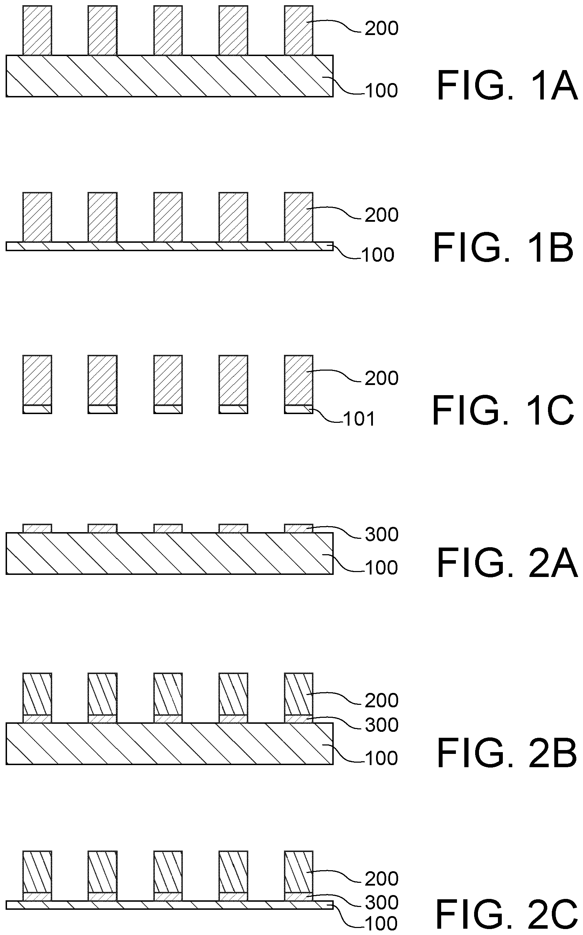

Bien que cela ne soit aucunement limitatif, l'invention est particulièrement intéressante pour des applications ayant besoin de générateurs thermoélectriques (GTE ou TEG pour "ThermoElectric Generator"), où un gradient thermique est disponible (exemple transports, industries, etc.), les applications de générateur thermoélectrique à radioisotope (GTR ou RTG pour "Radioisotope Thermoelectric Generators") en particulier pour SiGe, les applications Peltier ou encore les applications de capteurs thermiques. Comme représenté sur les Fig. 1A à 1C, 2A à 2D, 3A à 3E, 4A à 4F, 5A à 5C, 6A à 6D, le procédé de fabrication d'une structure thermoélectrique comprend les étapes suivantes :

a) fournir un substrat 100 en un premier matériau,
b) déposer un élément thermoélectrique 200 en un deuxième matériau sur le substrat 100, par fabrication additive, de préférence par frittage sélectif par laser (SLS) ou par fusion laser sur lit de poudre (FLLP),
c) amincir et découper le substrat 100 jusqu'à obtenir un film 101 en premier matériau, moyennant quoi on obtient une structure thermoélectrique comprenant un film 101 en premier matériau et l'élément thermoélectrique 200.

Le substrat 100 fourni à l'étape a) peut être un plateau ou un sur-plateau.

Dans les machines de fabrication additive, les sur-plateaux se fixent directement sur les plateaux, et permettent, non seulement, d'obtenir des épaisseurs plus fines (entre $200\mu$m et quelques millimètres), mais également, d'augmenter la nature des matériaux utilisables. Le sur-plateau est, avantageusement, en céramique.

Le substrat 100 est, par exemple, en un métal (par exemple Al, Ti, Cu, Au ou Ni), en un alliage métallique, en un matériau semi-conducteur, en céramique ou en graphite. Par exemple, il est en acier 316L, aluminium, titane, CuZr, céramique ou graphite.

Le substrat 100 peut avoir une épaisseur allant de quelques centaines de micromètres à quelques centimètres, et de préférence de quelques centaines de micromètres à quelques millimètres.

L'élément thermoélectrique 200 déposé à l'étape b) est en un deuxième matériau. Le deuxième matériau est, de préférence, choisi parmi Si, SiGe, MnSi $Bi_2Te_3$, Half-Heusler et Skutterudites. Les Skutterudites sont des espèces minérales composées d'arséniure de cobalt et de nickel de formule (Co, Ni)$As_{3-x}$ avec des traces de S, Bi, Cu, Pb, Zn, Ag, Fe et Ni.

L'élément thermoélectrique 200 peut être à conductivité de type N pour favoriser le déplacement des électrons (c'est-à-dire que le matériau qui le compose est à coefficient Seebeck strictement négatif) ou à conductivité de type P pour favoriser le déplacement des trous (c'est-à-dire que le matériau qui le compose est à coefficient Seebeck strictement positif).

Par exemple, le matériau thermoélectrique dopé de type N est un alliage silicium-germanium (SiGe) dopé par du phosphore ou du polysilicium dopé de type N. Le dopant de type N peut être du phosphore ou de l'arsenic.

Par exemple, le matériau de type P est un alliage silicium-germanium (SiGe) dopé par du bore ou encore du polysilicium dopé de type P. Le dopant de type P est préférentiellement du bore.

Avantageusement, le dopant est intégré directement dans la poudre de base.

L'élément thermoélectrique 200 peut être formé directement sur le substrat 100. Il est alors en contact direct avec le substrat 100.

Selon une variante de réalisation avantageuse, le substrat 100 fourni à l'étape a) peut être recouvert par une couche d'accroche 300 en un troisième matériau. Lors de l'étape b), l'élément thermoélectrique 200 est alors formé sur la couche d'accroche métallique 300. Il est directement en contact avec cette couche d'accroche 300. On obtient ainsi une structure thermoélectrique comprenant un film 101, une couche d'accroche 300 et un élément thermoélectrique200.

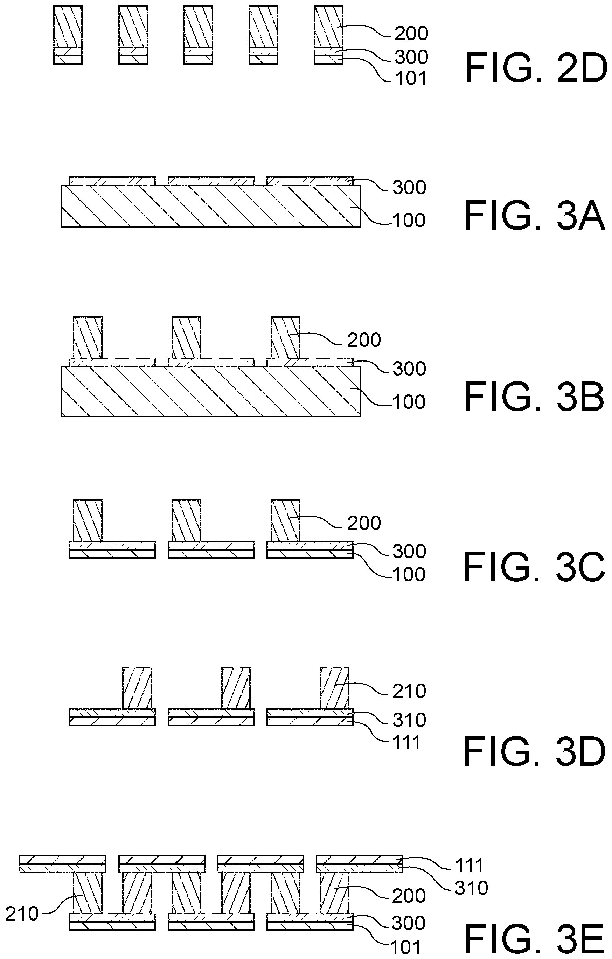

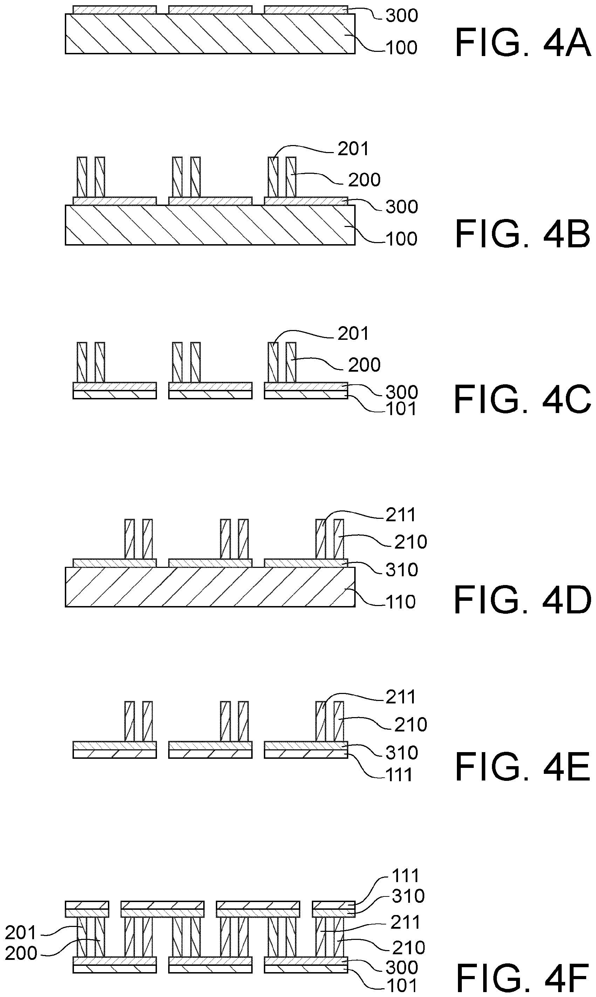

La couche d'accroche 300 peut recouvrir localement ou complètement le substrat 100. Par exemple, la couche d'accroche métallique 300 forme une pluralité d'ilots à la surface du substrat 100. Un élément thermoélectrique 200 peut être formé sur chaque ilot (Fig. 2B, 3B, 6A) ou plusieurs éléments thermoélectriques 200, 201 peuvent être formés sur chaque ilot (Fig. 4B).

Pour obtenir une couche d'accroche 300 recouvrant localement le substrat 100, il est possible de réaliser un dépôt localisé de cette couche. Alternativement, il est possible de réaliser un dépôt pleine plaque d'une couche continue suivi d'une étape au cours de laquelle on retire une partie de la couche continue, par exemple par gravure, pour former les ilots.

La couche d'accroche 300 peut être déposée, par exemple, par dépôt physique en phase vapeur (ou PVD pour "Physical Vapor Deposition" en anglais), évaporation, pulvérisation. Après le dépôt de la couche d'accroche 300, une étape de recuit peut être réalisée.

La couche d'accroche 300 est en un matériau différent de celui du substrat 100.

La couche d'accroche 300 est, par exemple, en métal ou en un alliage métallique. De préférence, le métal est choisi parmi Al, Ti, Cu, Au et Ni. Plusieurs couches peuvent être superposées, par exemple, il peut s'agit d'un bicouche ou d'un tricouche. On pourra choisir un tricouche formé d'une couche de cuivre, d'une couche de nickel et d'une couche d'or. À titre illustratif et non limitatif, il est possible de choisir un tricouche formé de Cu (par exemple 200nm) + Ni (par exemple 5$\mu$m) + Au (par exemple 10nm). L'élément thermoélectrique 200 déposé à l'étape b) est obtenu par fabrication additive. Le procédé consiste à déposer le matériau en plusieurs passes successives sur le substrat ou sur la couche d'accroche. À l'issue des dépôts successifs, on obtient l'élément thermoélectrique. Le substrat être un plateau ou un sur-plateau.

La technique de fabrication additive est, de préférence, une technique de fusion laser sur lit de poudre (FLLP ou PBF pour "Powder Bed Fusion" en terminologie anglo-saxonne) ou une technique de frittage sélectif par laser ("SLS" qui est l'acronyme pour "Selective Laser Sintering") selon la terminologie anglo-saxonne.

Les procédés FLLP consistent à faire fondre certaines régions d'un lit de poudre, par exemple au moyen d'un faisceau laser.

Dans le procédé SLS, les poudres sont frittées. Les matériaux des poudres ne passent pas en phase liquide.

Cependant, d'autres techniques de fabrication additive peuvent être envisagées, comme le "Cold Spray", "Electron Beam Melting", etc.

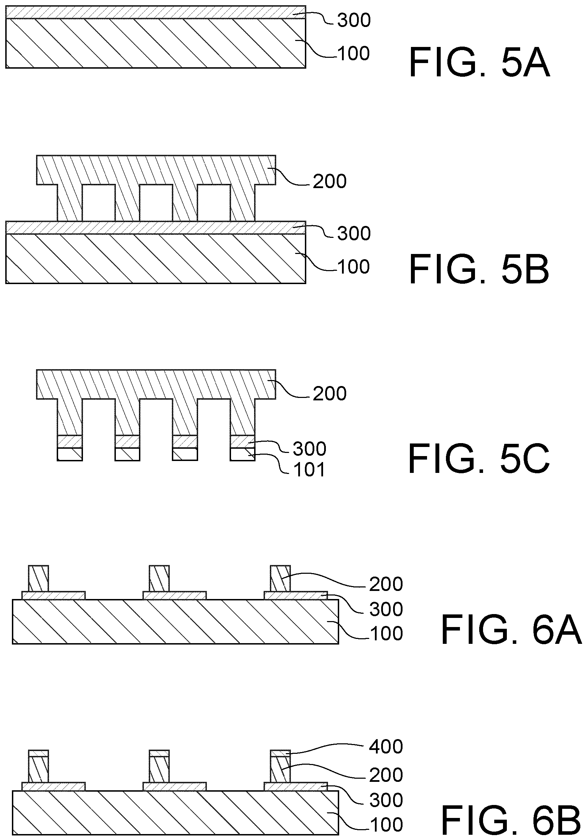

L'élément thermoélectrique 200 déposé à l'étape b) peut prendre plusieurs formes. Selon une première variante de réalisation avantageuse, l'élément thermoélectrique 200 est une pièce en forme de peigne (Fig. 5B).

La pièce a la forme d'un peigne délimitant une base et une pluralité de branches, sensiblement parallèles entre elles, s'étendant sensiblement orthogonalement à partir de la base. La pluralité de branches a une première extrémité et une deuxième extrémité. La première extrémité est reliée à la base, et la deuxième extrémité est en contact avec le film 101 ou, le cas échéant, en contact avec la couche d'accroche métallique 300.

Par "sensiblement orthogonal", on entend "orthogonal" ou "orthogonal à plus ou moins 10° de tolérance".

Par "sensiblement parallèle", on entend "parallèle" ou "parallèle à plus ou moins 10° de tolérance".

Selon une autre variante de réalisation, l'élément thermoélectrique 200 est un plot (Fig. 1B, 2B, 3B, 4B, 6A). Le plot a une base ayant une surface et une hauteur.

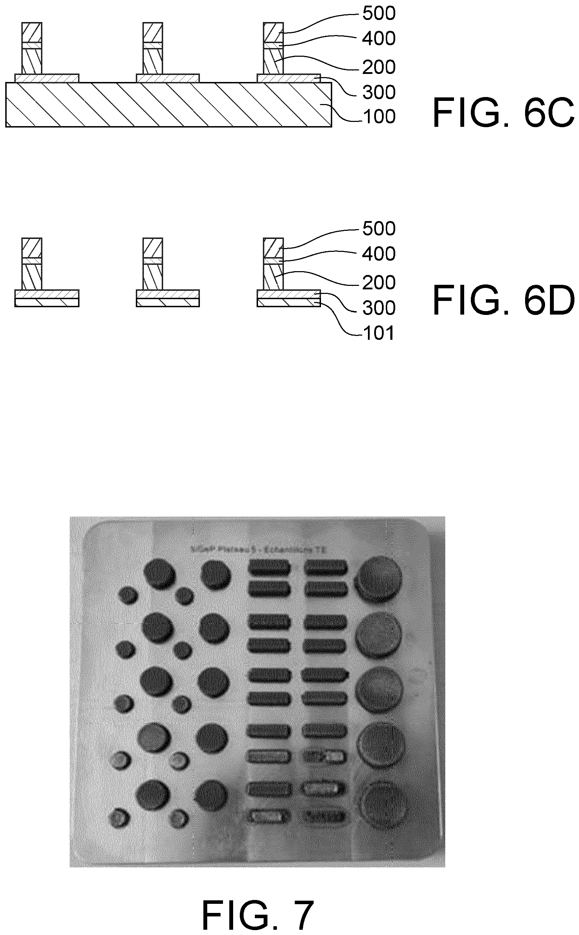

Selon un mode de réalisation particulier, entre l'étape b) et l'étape c), le procédé comprend une étape additionnelle au cours de laquelle on dépose sur l'élément thermoélectrique 200 une couche de métallisation intermédiaire 400 (Fig. 6B) puis un élément thermoélectrique additionnel 500 en un quatrième matériau (Fig. 6C). Le quatrième matériau est différent du deuxième matériau.

Après l'étape b), un recuit thermique peut être réalisé.

Lors de l'étape c), le substrat 100 est aminci et découpé pour former un film 200 en regard de l'élément thermoélectrique 200.

Le substrat 100 peut être aminci par laser, usinage mécanique, jet d'eau, électroérosion ou encore par usinage électrochimique.

Le substrat 100 peut être découpé par laser, scie à fil ...

Selon une première variante de réalisation, lors de l'étape c), le substrat 100 est découpé de manière à avoir un film 101 ayant une même surface que la surface de la base du plot ou de la deuxième extrémité des branches du peigne.

Selon une autre variante de réalisation, lors de l'étape c), le substrat 100 est découpé de manière à avoir un film 101 ayant une surface supérieure à la surface de la base du plot. De manière très avantageuse, lors de l'étape b), plusieurs plots 200, 201 sont déposés (Fig. 4B, 4D) et le substrat 100 est découpé de manière à avoir une structure comprenant un film 101 sur lequel sont disposés plusieurs plots 200, 201 (Fig. 4C, 4E).

À l'issue de l'étape c), on obtient ainsi une première structure thermoélectrique. Avantageusement, le procédé de fabrication précédemment décrit est mis en œuvre pour fabriquer une deuxième structure thermoélectrique (comme par exemple représenté sur les Fig. 3D et 4E).

La deuxième structure comprend un film 111 obtenu après amincissement et découpage du substrat 100 et un ou plusieurs éléments thermoélectriques 210, 211. Une couche d'accroche 310 peut être disposée entre le film 111 et le ou les éléments thermoélectriques 210, 211.

Le matériau thermoélectrique de la deuxième structure est d'un dopage différent de celui de la première structure.

Les deux structures obtenues sont, avantageusement, assemblées et connectées électriquement pour former un dispositif thermoélectrique (Fig. 3E et 4F).

Il est possible de connecter les dispositifs en série et/ou en parallèle. Il est avantageux de combiner des connexions série et des connexions en parallèle afin d'optimiser les performances électriques de sortie du dispositif thermoélectrique fabriqué.

Le cas échéant, les matériaux des couches métalliques 300, 310 des deux structures peuvent être identiques ou différents. Les matériaux des substrats 100, 110 utilisés peuvent être différents identiques ou différents.

L'invention est particulièrement intéressante pour fabriquer des modules thermoélectriques classiques, des substrats DBC, des modules thermoélectriques dit squelettes ou encore des plots thermoélectriques segmentés.

Le dispositif thermoélectrique obtenu peut fonctionner en mode Seebeck (i.e. le dispositif thermoélectrique est alors un générateur d'énergie électrique) ou en mode Peltier (i.e. le dispositif thermoélectrique est alors un générateur d'énergie thermique).

Nous allons maintenant décrire plus en détail différents modes de réalisation en faisant référence aux figures annexées.

Selon un premier mode de réalisation représenté aux Fig. 1A à 1C, le procédé comprend les étapes suivantes :

 a) fournir un substrat 100 en un premier matériau,
 b) déposer un plot thermoélectrique 200, et de préférence plusieurs plots thermoélectriques, en un deuxième matériau sur le substrat 100, par fabrication additive, de préférence par SLS ou FLLP,
 c) amincir et découper le substrat 100, moyennant quoi on obtient une ou plusieurs structures thermoélectriques comprenant chacune un plot thermoélectrique 200 recouvert par un film 101 en premier matériau.

Ce premier mode de réalisation est avantageux car il permet d'utiliser directement le matériau du substrat 100 (de préférence en métal ou en alliage métallique) pour la métallisation des plots 200.

Selon un deuxième mode de réalisation représenté sur les Fig. 2A à 2D, le procédé comprend les étapes suivantes :

 a) fournir un substrat 100 en un premier matériau, recouvert localement par une couche d'accroche métallique 300 en un troisième matériau, formant des ilots,
 b) déposer un plot thermoélectrique 200, et de préférence plusieurs plots thermoélectriques, en un deuxième matériau sur chaque ilot de la couche d'accroche 300, par fabrication additive, de préférence par SLS ou FLLP,
 c) amincir et découper le substrat 100, moyennant quoi on obtient plusieurs structures thermoélectriques comprenant chacune un plot thermoélectrique 200 recouvert successivement par une couche d'accroche 300 et un film 101 en premier matériau.

Ce deuxième mode de réalisation est avantageux car il permet d'utiliser directement le matériau du substrat 100 (plateau) pour la métallisation des plots 200, la tenue mécanique de la métallisation étant améliorée par la présence de la couche d'accroche 300.

Dans ces premiers modes de réalisation, le substrat 100 est découpé à la taille des plots 200.

Selon une variante de réalisation, le substrat 100 peut être découpé de manière avoir une surface supérieure à la surface de la base des plots 200.

Par exemple, selon un troisième mode de réalisation, représenté aux Fig. 3A à 3C, le procédé comprend les étapes suivantes :

 a) fournir un substrat 100 en un premier matériau, recouvert localement par une couche d'accroche métallique 300 en un troisième matériau, formant des ilots,

b) déposer un plot thermoélectrique 200, en un deuxième matériau sur le substrat 100, par fabrication additive, de préférence par SLS ou FLLP, sur chaque ilot,

c) amincir et découper le substrat 100, moyennant quoi on obtient plusieurs structures comprenant chacune un film 101 en premier matériau recouvert par une couche d'accroche 300 puis par un plot thermoélectrique 200.

Avantageusement, le même procédé est mis en œuvre pour fabriquer d'autres structures thermoélectriques comprenant chacune un film 111 en premier matériau recouvert par une couche d'accroche 310 puis par un plot thermoélectrique en un quatrième matériau de conductivité opposée à la conductivité du deuxième matériau (Fig. 3D). Les deux dispositifs sont ensuite assemblés pour former, de préférence, des modules squelettes (Fig. 3E).

Par exemple, selon un quatrième mode de réalisation, représenté aux Fig. 4A à 4C, le procédé comprend les étapes suivantes :

a) fournir un substrat 100 en un premier matériau, recouvert localement par une couche d'accroche métallique 300 en un troisième matériau, formant des ilots,

b) déposer plusieurs plots thermoélectriques 200, 201, en un deuxième matériau sur chaque ilot de la couche d'accroche métallique 300, par fabrication additive, de préférence par SLS ou FLLP,

c) amincir et découper le substrat 100, moyennant quoi on obtient une structure comprenant un film 101 en premier matériau recouvert par une couche d'accroche 300, sur laquelle sont disposées plusieurs plots thermoélectriques 200, 201.

Avantageusement, le même procédé est mis en œuvre pour fabriquer une structure additionnelle à partir d'un substrat 110, recouvert localement par une couche d'accroche métallique 310 sur laquelle sont formées plusieurs plots 210, 211 par fabrication additive (Fig. 4D à 4F).

Cette structure additionnelle comprend un film 111 recouvert par une couche d'accroche 310 sur laquelle sont disposés plusieurs plots thermoélectriques 210, 211 de conductivité opposée à la conductivité des plots 200, 201 de la première structure (Fig. 4E). Les deux dispositifs sont ensuite assemblés pour former, de préférence, des modules squelettes (Fig. 4F).

Ce quatrième mode de réalisation est particulièrement intéressant car il permet de combiner des connexions série / parallèle et ainsi optimiser les performances électriques de sortie. En effet, il est possible de relier électriquement à façon les différents plots thermoélectriques. Usuellement, tous les plots sont reliés électriquement en série. Mais ceci peut amener à obtenir des tensions de sortie élevées (de plusieurs volts), ce qui est incompatible avec une électronique associée ("power management unit") pour laquelle les tensions sont généralement de quelques volts. Ce mode de réalisation permet de relier certains plots en parallèle tout en diminuant la tension de sortie, et tout en maintenant la puissance générée.

Selon un cinquième mode de réalisation représenté sur les Fig. 5A à 5C, le procédé comprend les étapes suivantes :

a) fournir un substrat 100 en un premier matériau, recouvert par une couche d'accroche métallique 300 en un troisième matériau,

b) former une pièce thermoélectrique 200 en forme de peigne, en un deuxième matériau sur la couche d'accroche métallique 300, par fabrication additive, de préférence par SLS ou FLLP, la pièce étant un peigne,

c) amincir et découper le substrat 100, et découper la couche d'accroche 300, moyennant quoi on obtient un peigne 200 dont la deuxième extrémité des branches est recouverte par une couche d'accroche 300 et un film 101 en premier matériau.

Le même procédé est mis en œuvre pour fabriquer un peigne d'un type de conductivité opposé au type de conductivité du deuxième matériau. Les deux peignes sont ensuite assemblés.

Selon un sixième mode de réalisation représenté sur les Fig. 6A à 6D, le procédé comprend les étapes suivantes :

a) fournir un substrat 100 en un premier matériau, recouvert localement par une couche d'accroche 300, formant des ilots,

b) déposer un plot thermoélectrique 200 en un deuxième matériau sur chaque ilot de la couche d'accroche 300, par fabrication additive, de préférence par SLS ou FLLP, puis une couche de métallisation 400 et un autre élément thermoélectrique 500 en un quatrième matériau,

c) amincir et découper le substrat 100, jusqu'à obtenir un film 101 en un premier matériau, moyennant quoi on obtient des structures thermoélectriques comprenant chacune un film 101, une couche d'accroche 300, un premier plot thermoélectrique 200, une couche de métallisation 400 puis un second plot thermoélectrique 500.

Ce mode de réalisation est particulièrement avantageux pour fabriquer des plots thermoélectriques segmentés.

Exemples illustratifs et non limitatifs d'un mode de réalisation :

Dans cet exemple, des éléments thermoélectriques en SiGe, sous forme de plot, ont été fabriquées par SLS. Les éléments thermoélectriques peuvent avoir une épaisseur de 500 $\mu$m à quelques centimètres.

Le plateau est en Inox 316L.

La Fig. 7 représente des éléments thermoélectriques ainsi fabriqués.

## Revendications

1. Procédé de fabrication d'une structure thermoélectrique comprenant les étapes suivantes :

   a) fournir un substrat (100) en un premier matériau,

   b) déposer un élément thermoélectrique (200) en un deuxième matériau sur le substrat (100), par fabrication additive, de préférence par frittage sélectif par laser ou par fusion laser sur lit de poudre,

   c) amincir et découper le substrat (100), jusqu'à obtenir un film (101) en premier matériau, moyennant quoi on obtient une structure thermoélectrique comprenant un film (101) et l'élément thermoélectrique (200).

2. Procédé selon la revendication précédente, **caractérisé en ce que** le substrat (100) est recouvert, complètement ou localement, par une couche d'accroche (300) métallique en un troisième matériau et **en ce que** l'élément thermoélectrique (200) est formé sur la couche d'accroche (300), moyennant quoi on obtient une structure thermoélectrique comprenant un film (101), une couche d'accroche (300) et un élément thermoélectrique (200), le troisième matériau étant de préférence choisi parmi Al, Ti, Cu, Au et Ni.

3. Procédé selon la revendication 1 ou 2, **caractérisé en ce que** l'élément thermoélectrique (200) est une pièce ayant la forme d'un peigne délimitant une base et une pluralité de branches, sensiblement parallèles entre elles, s'étendant sensiblement orthogonalement à partir de la base, la pluralité de branches ayant une première extrémité et une deuxième extrémité, la première extrémité étant reliée à la base, et la deuxième extrémité étant en contact avec le film (101) ou, le cas échéant, en contact avec la couche d'accroche (300) métallique.

4. Procédé selon la revendication 1 ou 2, **caractérisé en ce que** l'élément thermoélectrique (200) est un plot, ayant une base et une hauteur.

5. Procédé selon la revendication 4, **caractérisé en ce que** le substrat (100) est découpé de manière à avoir un film (101) ayant une même surface que la surface de la base du plot.

6. Procédé selon la revendication 4, **caractérisé en ce que** le substrat (100) est découpé de manière à avoir un film (101) ayant une surface supérieure à la surface de la base du plot.

7. Procédé selon l'une quelconque des revendications 4 à 6, **caractérisé en ce que**, entre l'étape b) et l'étape c), le procédé comprend une étape additionnelle au cours de laquelle on dépose, sur l'élément thermoélectrique (200), une couche de métallisation intermédiaire (400) puis un élément thermoélectrique additionnel (500) en un quatrième matériau ayant un type de conductivité opposé au type de conductivité du deuxième matériau.

8. Procédé selon la revendication 6 ou 7, **caractérisé en ce que**, lors de l'étape b), plusieurs plots sont déposés et **en ce que** le substrat (100) est découpé de manière à avoir une structure comprenant un film (101) sur lequel sont disposés plusieurs plots.

9. Procédé selon l'une quelconque des revendications précédentes, **caractérisé en ce que** le deuxième matériau est choisi parmi Si, SiGe, $Bi_2Te_3$, Half-Heusler et Skutterudites.

10. Procédé selon l'une quelconque des revendications précédentes, **caractérisé en ce que** le premier matériau est de l'acier 316L, de l'aluminium, du titane, un alliage CuZr, une céramique ou du graphite.

11. Structure thermoélectrique obtenue par le procédé selon l'une quelconque des revendications précédentes, comprenant un film (101), par exemple en acier 316L, aluminium, titane, alliage CuZr, céramique ou graphite, sur lequel est disposé un ou plusieurs éléments thermoélectriques (200).

12. Structure thermoélectrique selon la revendication précédente, **caractérisée en ce qu'**une couche d'accroche (300) métallique, par exemple en Al, Ti, Cu, Au ou Ni, est disposée entre le film (101) et le ou les éléments thermoélectriques (200).

13. Dispositif thermoélectrique comprenant deux structures thermoélectriques selon la revendication 11 ou 12, chaque structure comprenant un film (101, 111), par exemple en acier 316L, aluminium, titane, alliage CuZr, céramique ou graphite, et un ou plusieurs éléments thermoélectriques (200, 201, 210, 211),

   une couche d'accroche (300, 310) métallique, par exemple en Al, Ti, Cu, Au ou Ni, pouvant être disposée entre le film (101, 111) et le ou les éléments thermoélectriques (200, 201, 210, 211) des deux structures thermoélectriques, le ou les éléments thermoélectriques d'une des structures thermoélectrique étant d'un premier type de conductivité et le ou les éléments thermoélectriques de l'autre structure thermoélectrique étant d'un deuxième type de conductivité opposé au premier type de conductivité.

**Patentansprüche**

1. Verfahren zum Herstellen einer thermoelektrischen Struktur, das die folgenden Schritte umfasst:

   a) Bereitstellen eines Substrats (100) aus einem ersten Material,
   b) Abscheiden eines thermoelektrischen Elements (200) aus einem zweiten Material auf dem Substrat (100) durch additive Fertigung, vorzugsweise durch selektives Lasersintern oder durch Pulverbett-Laserschmelzen,
   c) Ausdünnen und Schneiden des Substrats (100), bis ein Film (101) aus dem ersten Material erhalten wird, wodurch eine thermoelektrische Struktur erhalten wird, die einen Film (101) und das thermoelektrische Element (200) umfasst.

2. Verfahren nach dem vorhergehenden Anspruch, **dadurch gekennzeichnet, dass** das Substrat (100) vollständig oder stellenweise mit einer metallischen Haftschicht (300) aus einem dritten Material bedeckt wird und dass das thermoelektrische Element (200) auf der metallischen Haftschicht (300) ausgebildet wird, wodurch eine thermoelektrische Struktur erhalten wird, die einen Film (101), eine Haftschicht (300) und ein thermoelektrisches Element (200) umfasst, wobei das dritte Material vorzugsweise aus Al, Ti, Cu, Au und Ni ausgewählt ist.

3. Verfahren nach Anspruch 1 oder 2, **dadurch gekennzeichnet, dass** das thermoelektrische Element (200) ein Bauteil in Form eines Kamms ist, der eine Basis und eine Vielzahl von Armen begrenzt, die im Wesentlichen parallel zueinander sind und sich im Wesentlichen orthogonal von der Basis erstrecken, wobei die Vielzahl von Armen ein erstes Ende und ein zweites Ende aufweist, wobei das erste Ende mit der Basis verbunden ist und das zweite Ende in Kontakt mit dem Film (101) oder gegebenenfalls in Kontakt mit der metallischen Haftschicht (300) steht.

4. Verfahren nach Anspruch 1 oder 2, **dadurch gekennzeichnet, dass** das thermoelektrische Element (200) ein Stift ist, der eine Basis und eine Höhe aufweist.

5. Verfahren nach Anspruch 4, **dadurch gekennzeichnet, dass** das Substrat (100) derart geschnitten wird, dass es einen Film (101) aufweist, der eine gleiche Oberfläche wie die Oberfläche der Basis des Stifts aufweist.

6. Verfahren nach Anspruch 4, **dadurch gekennzeichnet, dass** das Substrat (100) derart geschnitten wird, dass es einen Film (101) aufweist, der eine Oberfläche aufweist, die größer als die Oberfläche der Basis des Stifts ist.

7. Verfahren nach einem der Ansprüche 4 bis 6, **dadurch gekennzeichnet, dass** das Verfahren zwischen dem Schritt b) und dem Schritt c) einen zusätzlichen Schritt umfasst, bei dem eine Zwischenmetallisierungsschicht (400) und dann ein zusätzliches thermoelektrisches Element (500) aus einem vierten Material, das von einem Leitfähigkeitstyp ist, der dem Leitfähigkeitstyp des zweiten Materials entgegengesetzt ist, auf dem thermoelektrischen Element (200) abgeschieden werden.

8. Verfahren nach Anspruch 6 oder 7, **dadurch gekennzeichnet, dass** in Schritt b) mehrere Stifte abgeschieden werden und dass das Substrat (100) derart geschnitten wird, dass es eine Struktur aufweist, die einen Film (101) umfasst, auf dem mehrere Stifte angeordnet sind.

9. Verfahren nach einem der vorhergehenden Ansprüche, **dadurch gekennzeichnet, dass** das zweite Material aus Si, SiGe, $Bi_2Te_3$, Half-Heusler und Skutteruditen ausgewählt ist.

10. Verfahren nach einem der vorhergehenden Ansprüche, **dadurch gekennzeichnet, dass** das erste Material 316L-Stahl, Aluminium, Titan, eine CuZr-Legierung, eine Keramik oder Graphit ist.

11. Thermoelektrische Struktur, die durch das Verfahren nach einem der vorhergehenden Ansprüche erhalten wird und einen Film (101), zum Beispiel aus 316L-Stahl, Aluminium, Titan, CuZr-Legierung, Keramik oder Graphit, umfasst, auf dem ein oder mehrere thermoelektrische Elemente (200) angeordnet sind.

12. Thermoelektrische Struktur nach dem vorhergehenden Anspruch, **dadurch gekennzeichnet, dass** zwischen dem Film (101) und dem bzw. den thermoelektrischen Elementen (200) eine metallischen Haftschicht (300), zum Beispiel aus Al, Ti, Cu, Au oder Ni, ist.

13. Thermoelektrische Vorrichtung, die zwei thermoelektrische Strukturen nach Anspruch 11 oder 12 umfasst, wobei jede Struktur einen Film (101, 111), zum Beispiel aus 316L-Stahl, Aluminium, Titan, CuZr-Legierung, Keramik oder Graphit, und ein oder mehrere thermoelektrische Elemente (200, 201, 210, 211) umfasst,

wobei zwischen dem Film (101, 111) und dem bzw. den thermoelektrischen Elementen (200, 201, 210, 211) der beiden thermoelektrischen Strukturen eine metallische Haftschicht (300, 310), zum Beispiel aus Al, Ti, Cu, Au oder Ni, angeordnet werden kann,

wobei das bzw. die thermoelektrischen Elemente einer der thermoelektrischen Strukturen von einem ersten Leitfähigkeitstyp sind und das bzw. die thermoelektrischen Elemente der anderen thermoelektrischen Struktur von einem zweiten Leitfähigkeitstyp sind, der dem ersten Leitfähigkeitstyp entgegengesetzt ist.

**Claims**

1. A method for manufacturing a thermoelectric structure comprising the following steps:

   a) providing a substrate (100) made of a first material,
   b) depositing a thermoelectric element (200) made of a second material on the substrate (100), by additive manufacturing, preferably by selective laser sintering or by laser powder bed fusion,
   c) thinning and cutting the substrate (100), until a film (101) made of first material is obtained, whereby a thermoelectric structure comprising a film (101) and the thermoelectric element (200) is obtained.

2. The method according to the preceding claim, **characterised in that** the substrate (100) is covered, completely or locally, by a metallic bonding layer (300) made of a third material and **in that** the thermoelectric element (200) is formed on the bonding layer (300), whereby a thermoelectric structure comprising a film (101), a bonding layer (300) and a thermoelectric element (200) is obtained, the third material preferably being selected from Al, Ti, Cu, Au and Ni.

3. The method according to claim 1 or 2, **characterised in that** the thermoelectric element (200) is a part having the shape of a comb delimiting a base and a plurality of branches, substantially parallel to each other, extending substantially orthogonally from the base, the plurality of branches having a first end and a second end, the first end being connected to the base, and the second end being in contact with the film (101) or, where appropriate, in contact with the metal bonding layer (300).

4. The method according to claim 1 or 2, **characterised in that** the thermoelectric element (200) is a pad, having a base and a height.

5. The method according to claim 4, **characterised in that** the substrate (100) is cut so as to have a film (101) having the same surface as the surface of the base of the pad.

6. The method according to claim 4, **characterised in that** the substrate (100) is cut so as to have a film (101) having a surface greater than the surface of the base of the pad.

7. The method according to any one of claims 4 to 6, **characterised in that**, between step b) and step c), the method comprises an additional step during which an intermediate metallisation layer (400) then an additional thermoelectric element (500) made of a fourth material having a conductivity type opposite to the conductivity type of the second material, are deposited on the thermoelectric element (200).

8. The method according to claim 6 or 7, **characterised in that**, during step b), several pads are deposited and **in that** the substrate (100) is cut so as to have a structure comprising a film (101) on which several pads are disposed.

9. The method according to any one of the preceding claims, **characterised in that** the second material is selected from Si, SiGe, $Bi_2Te_3$, Half-Heusler and Skutterudites.

10. The method according to any one of the preceding claims, **characterised in that** the first material is 316L steel, aluminium, titanium, a CuZr alloy, a ceramic or graphite.

11. A thermoelectric structure obtained by the method according to any one of the preceding claims, comprising a film (101), for example made of 316L steel, aluminium, titanium, CuZr alloy, ceramic or graphite, on which one or more thermoelectric elements (200) are disposed.

12. The thermoelectric structure according to the preceding claim, **characterised in that** a metallic bonding layer (300), for example made of Al, Ti, Cu, Au or Ni, is disposed between the film (101) and the thermoelectric element(s) (200).

13. The thermoelectric device comprising two thermoelectric structures according to claim 11 or 12, each structure comprising a film (101,111), for example made of 316L steel, aluminium, titanium, CuZr alloy, ceramic or graphite, and one or more thermoelectric elements (200, 201, 210, 211),

a metallic bonding layer (300, 310), for example made of Al, Ti, Cu, Au or Ni, which can be disposed between the film (101, 111) and the thermoelectric element(s) (200, 201, 210, 211) of the two thermoelectric structures,

the thermoelectric element(s) of one of the thermoelectric structures being of a first conductivity type and the thermoelectric element(s) of the other thermoelectric structure being of a second conductivity type opposite to the first conductivity type.

FIG. 1A

200
100

FIG. 1B

200
100

FIG. 1C

200
101

FIG. 2A

300
100

FIG. 2B

200
300
100

FIG. 2C

200
300
100

FIG. 2D

FIG. 3A

FIG. 3B

FIG. 3C

FIG. 3D

FIG. 3E

FIG. 4A

FIG. 4B

FIG. 4C

FIG. 4D

FIG. 4E

FIG. 4F

300
100

**FIG. 5A**

200
300
100

**FIG. 5B**

200
300
101

**FIG. 5C**

200
300
100

**FIG. 6A**

400
200
300
100

**FIG. 6B**

FIG. 6C

FIG. 6D

FIG. 7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

*   WO 2020066948 A1